# EUROPEAN PATENT APPLICATION

(11) **EP 4 461 685 A1**
(43) Date of publication of application: **13.11.2024**
(21) Application number: 23202430.7
(22) Date of filing: 09.10.2023
(51) Int. Cl.: B66B 5/00

(54) **SOLUTION FOR EVALUATING A QUALITY OF AN ELEVATOR DOOR INSTALLATION**

(30) Priority: 12.05.2023 WO PCT/FI2023/050263
(71) Applicant: KONE Corporation, 00330 Helsinki (FI)
(72) Inventor: Roivainen, Gabriela, 00330 Helsinki (FI); Matti, Lin, 00330 Helsinki (FI)
(74) Representative: Berggren Oy

(57) **Abstract**

A computer-implemented methods and computing apparatuses as well as computer programs are provided for evaluating a quality of an installation of an elevator door. A part of the methods, apparatuses and computer programs are for generating a machine-learning model for the task whereas another part of the methods, apparatuses and computer programs are for evaluating the quality of the installation of the elevator door.

## Description

### TECHNICAL FIELD

The invention concerns in general the technical field of elevators. More particularly, the invention concerns an evaluation of an installation quality of an elevator door.

### BACKGROUND

Elevator doors are moving parts that are under a heavy use in elevator systems. An initial installation quality of the elevator doors, and later building and system relaxation has an effect on correct position of lock rollers on a landing door relative to coupler vanes of the elevator car door, as well as on acceptable lock clearance between lock hook and the counterpart.

Decrease of the lock clearance and a misalignment of lock rollers may also be caused, for example, by various decorations of the elevator car, balancing weight position or people location in the car. Too small lock clearance and misalignment of lock rollers may cause door jamming and an entrapment of elevator passengers.

In order to avoid the fault operation of the elevator door a lot of effort is used for safeguarding a correct installation of the elevator doors. The quality of installation may be performed by monitoring an operation of the elevator doors during and upon the installation. Traditionally, the monitoring is based on capturing operational data from the elevator doors e.g. with sensors and the obtained measurement data descriptive of the operation of the elevator door is compared to reference data and based on the result of the comparison conclusions are made of the condition of the elevator doors. The traditional approach is based on so-called fixed condition key performance indicators (KPI) used as the reference data. For example, one such KPI may be a maximum force, i.e. the maximum force used for moving the elevator door, determined e.g. from a current input to the electric motor of the elevator door. The approach is applicable as such, but it has a drawback that the approach is fixed to a predefined number of KPIs not making it flexible. This also means that the KPIs need to be defined for all door types separately thus requiring a lot of resources to implement. This becomes especially visible when the KPIs need to be changed since the implementation, the testing and the validation take a lot of time.

Therefore, there is a need to introduce more sophisticated approaches in improving an installation operation of the elevator doors.

### SUMMARY

The following presents a simplified summary in order to provide basic understanding of some aspects of various invention embodiments. The summary is not an extensive overview of the invention. It is neither intended to identify key or critical elements of the invention nor to delineate the scope of the invention. The following summary merely presents some concepts of the invention in a simplified form as a prelude to a more detailed description of exemplifying embodiments of the invention.

An object of the invention is to present a method, a computing apparatus and a computer program for generating data descriptive of a quality of an installation of an elevator door. Another object of the invention is to present a method, a computing apparatus and a computer program for training a machine-learning model for evaluating a quality of an installation of an elevator door.

The objects of the invention are reached by methods, computing apparatuses and computer programs as defined by the respective independent claims.

According to a first aspect, a computer-implemented method for generating data descriptive of a quality of an installation of an elevator door is provided, the method is performed by a computing apparatus configured to execute a machine learning-model trained at least with a simulation data of a simulation model corresponding to an installed elevator door for evaluating the quality of the installation of the elevator door, the method comprises:
receiving data descriptive of an operation of the installed elevator door, the data is generated over at least portion of an operational cycle of the installed elevator door,
inputting the data descriptive of an operation of the installed elevator door to the machine-learning model,
setting, in accordance with an output from the machine-learning model, a detection result to express one of the following: (i) the installed elevator door operates in an acceptable manner, (ii) the installed elevator door operates in an unacceptable manner.

The data descriptive of the operation of the installed elevator door may be received from a coupling phase of the elevator door. Moreover, the data descriptive of the operation of the installed elevator door may correspond to data descriptive of a belt position and data descriptive of a speed of the elevator door during the coupling phase of the elevator door.

According to a second aspect, a computing apparatus for generating data descriptive of a quality of an installation of an elevator door is provided, the computing apparatus is configured to execute a machine learning-model trained at least with a simulation data of a simulation model corresponding to an installed elevator door for evaluating the quality of the installation of the elevator door, the computing apparatus further configured to:
receive data descriptive of an operation of the installed elevator door, the data is generated over at least portion of an operational cycle of the installed elevator door,
input the data descriptive of an operation of the installed elevator door to the machine-learning model,
set, in accordance with an output from the machine-learning model, a detection result to express one of the following: (i) the installed elevator door operates in an acceptable manner, (ii) the installed elevator door operates in an unacceptable manner.

The computing apparatus may be arranged to receive the data descriptive of the operation of the installed elevator door from a coupling phase of the elevator door. Moreover, the data descriptive of the operation of the installed elevator door correspond to data descriptive of a belt position and data descriptive of a speed of the elevator door during the coupling phase of the elevator door.

According to a third aspect, a computer program is provided, the computer program comprising instructions to cause the computing apparatus according to the second aspect as defined above to execute the steps of the method according to the first aspect as defined above.

According to a fourth aspect, a computer-implemented method for training a machine-learning model for evaluating a quality of an installation of an elevator door is provided, the method, performed by a computing apparatus, comprises:
receiving simulation data from a simulation model of an elevator door,
training the machine-learning model with at least part of the simulation data being descriptive of an operation of an entity of the elevator door that is common to a plurality of elevator door types.

The at least part of the simulation data may be descriptive of a coupling phase of the elevator door.

According to a fifth aspect, a computing apparatus for training a machine-learning model for evaluating a quality of an installation of an elevator door is provided, the computing apparatus is configured to:
receive simulation data from a simulation model of an elevator door,
train the machine-learning model with at least part of the simulation data being descriptive of an operation of an entity of the elevator door that is common to a plurality of elevator door types.

The at least part of the simulation data may be descriptive of a coupling phase of the elevator door.

According to a sixth aspect, a computer program is provided, the computer program comprising instructions which, when the program is executed by a computing apparatus, cause the computing apparatus to carry out the method of claim according to the fourth aspect as defined above.

The expression "a number of" refers herein to any positive integer starting from one, e.g. to one, two, or three.

The expression "a plurality of" refers herein to any positive integer starting from two, e.g. to two, three, or four.

Various exemplifying and non-limiting embodiments of the invention both as to constructions and to methods of operation, together with additional objects and advantages thereof, will be best understood from the following description of specific exemplifying and non-limiting embodiments when read in connection with the accompanying drawings.

The verbs "to comprise" and "to include" are used in this document as open limitations that neither exclude nor require the existence of unrecited features. The features recited in dependent claims are mutually freely combinable unless otherwise explicitly stated. Furthermore, it is to be understood that the use of "a" or "an", i.e. a singular form, throughout this document does not exclude a plurality.

### BRIEF DESCRIPTION OF FIGURES

The embodiments of the invention are illustrated by way of example, and not by way of limitation, in the figures of the accompanying drawings.
Figure 1 illustrates schematically entities in relation to the invention according to an example.
Figure 2 illustrates schematically a method according to an example.
Figures 3A and 3B illustrate schematically operational curves of an elevator door.
Figure 4 illustrates schematically a method according to another example.
Figure 5 illustrates schematically an apparatus according to an example.

### DESCRIPTION OF THE EXEMPLIFYING EMBODIMENTS

The specific examples provided in the description given below should not be construed as limiting the scope and/or the applicability of the appended claims. Lists and groups of examples provided in the description given below are not exhaustive unless otherwise explicitly stated.

The present invention is for evaluating a quality of an installation of an elevator door and the aim is at least to generate data descriptive on that. The installation of the elevator door corresponds to a situation that a setup of the elevator door is changed in some manner but also that a new installation is performed. In response to the installation work there is a need to confirm that the operation of the newly installed elevator door meets expectations and the present invention provides a mechanism for that.

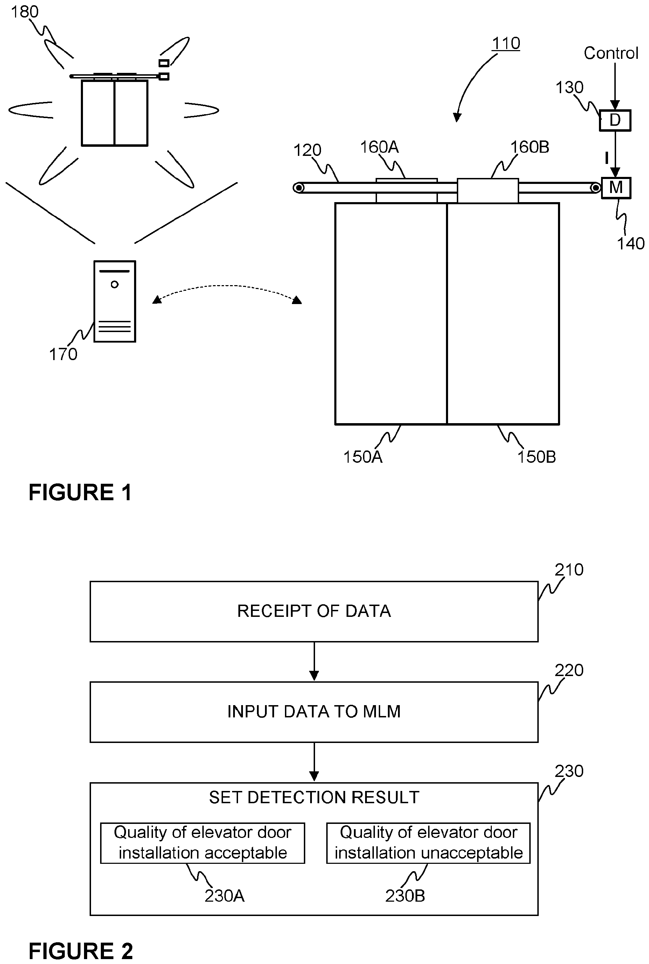

In the forthcoming description at least some aspects of the invention are described by referring to Figure 1 . Figure 1 illustrates schematically at least some entities of a system according to an embodiment enabling an implementation of the invention as is described in the following. The system comprises an elevator system consisting of a plurality of entities to make it operative. Figure 1 illustrates an elevator door system 110 and a computing apparatus 170 that may be considered as an evaluation unit of data input to it. In the non-limiting example of Figure 1 the computing apparatus 170 may be associated to the elevator door system 110, but it may reside in another location to the premises the elevator door system 110 resides. In any case the computing apparatus 170 is communicatively connected to the elevator door system 110 in a manner as becomes clear from the forthcoming description. Naturally, a functionality of the apparatus 170 may be integrated, in at least some embodiments, to one or more other entities, such as to the elevator controller or to an apparatus not physically associated to the elevator system, for instance.

Regarding the computing apparatus 170 it shall be considered as a computing device arranged to receive predefined type of data as an input. The data may e.g. refer to measurement data e.g. received from a sensor system or from entities belonging to the target under measurement. In accordance with an embodiment of the present invention the measurement data may be obtained from the elevator door system 110 and it may represent various parameters descriptive of the operation of the elevator door system 100. For example, the measurement data may e.g. represent a position of the door belt which, in turn, represents a position of the elevator door. The elevator door system 110 comprises a number of door panels 150A, 150B that are associated with the door belt 120 with so-called hanger plates 160A, 160B. For example, based on the position monitoring of the elevator belt 120 extreme points of the elevator door, cf. door panels, may be determined. Another aspect under monitoring may be a belt force that is descriptive of the force applied to moving the door. The belt force may be determined from a current intensity, I, supplied by an elevator door drive 130 to an electric motor 140 generating a rotational force to a shaft that causes the movement of the belt 120 in a known manner. The control of the elevator door drive 130 may come from an elevator controller or from an external source, such as from a testing device. A further parameter applicable in an evaluation of the operation of the elevator door may be a speed of the elevator door during a movement. The speed of the elevator door may e.g. be determined based on data obtainable from an encoder of the electric motor 140 or based on data obtainable from an applicable speed sensor mounted to the elevator door. The speed may also be determined from data descriptive of the change of the position of the door belt 120 in time. In other words, the data descriptive of the speed of the elevator door may be obtained from known sources and in a known manner. For sake of clarity it is worthwhile to mention that the speed of the elevator door shall be understood as a value descriptive of a motion of at least one entity of the elevator system 110 moving during an opening or a closing of the elevator door. Such entities may be the door panels 150A, 150B, the hanger plates 160A, 160B, the door belt 120 and the shaft of the electric motor 140 for example. For avoidance of doubt it is worth noting that the measurement data may comprise one or more different types of data, such as any combination of the above mentioned parameters (cf. properties), i.e. the position, the force, and/or the speed. Each category of the measurement data may comprise one or more values.

In accordance with at least one embodiment of the present invention a collection of the measurement data as described may be triggered on a basis of the elevator door movement in a predefined manner. For example, the collection of the measurement data may be triggered upon a control signal, i.e. the current, is supplied to the electric motor 140 of the elevator door. Alternatively or in addition, the collection of the measurement data may be made dependent on that a movement of the door panel 150A, 150B is detected. This may e.g. be based on a solution in which a sensor arrangement for detecting the movement is applied to. The triggering event for collecting the measurement data may also be the door coupling event at which a landing door of the elevator door and the elevator car door of the elevator door are engaged for harmonious movement of these two. The triggering based on the movement of the elevator door may be arranged to the opening direction as well as the closing direction of the respective elevator door. The above described triggering approach has an advantage that the computing apparatus 170 only receives meaningful data and, thus, the computing resources as well as the data storage resources are optimized since there does not occur the collection of data when the elevator doors are closed e.g. during a travel of the elevator car.

In accordance with at least some embodiments of the invention there may be one or more special phases in the movement of the elevator door that they may be in a special focus when obtaining the measurement data. As mentioned above, the elevator door coupling phase may be under interest. In order to obtain data descriptive on the coupling phase of the elevator door the measurement of the belt force together with the belt position are essential in accordance with an embodiment.

Further aspects of at least some embodiments of the present invention are described by referring to Figure 2 schematically illustrating a method according to an example. In step 210 the computing apparatus 170 receives data descriptive of the operation of the installed elevator door wherein the data is generated over at least portion of an operational cycle of the installed elevator door. In other words, the data received may be obtained in the manner as described in the foregoing description in relation to Figure 1. Thus, the received data may comprise a number of data values descriptive of one or more parameters (cf. properties) during the operational cycle of the elevator door. The data may be called as a measurement data.

The data received by the computing apparatus 170, or at least part of it, is input 220 to a machine-learning model executed by the computing apparatus 170. The machine-learning model is trained to the task in a manner as depicted in the forthcoming description. The computing apparatus 170 is arranged to set 230, in accordance with an output from the machine-learning model, a detection result to express one of the following: (i) the installed elevator door operates in an acceptable manner 230A, (ii) the installed elevator door operates in an unacceptable manner 230B. Thus, the machine-learning model is trained to evaluate the input data and to generate an output based on which the computing apparatus 170 may set 230 the detection result as mentioned.

In some example embodiments the computing apparatus 170 may be configured to output the detection result to another entity, especially in a case that the detection result indicates that the installed elevator door operates in an unacceptable manner. The output of the detection result to the other entity may refer to an implementation that the computing apparatus 170 is configured to generate a message and transmit it over a predefined communication channel to a terminal device of a technician being responsible for the installation work, for example. The computing apparatus 170 may also be configured to include further details in the message, such as repairing instructions to overcome the situation in which the installed elevator door operates in an unacceptable manner. Such information may be obtained from data storage accessible to the computing apparatus 170 e.g. based on a result of evaluation received from the machine-learning model. Alternatively or in addition, such information may be obtained based on measurement data deviating from the data as expected which deviation may be considered as an indicator of a root cause of the unacceptable installation.

As regards to the training of the machine-learning model it may be performed with a simulation data of a simulation model which refers to a virtual digital model, also callable as a digital twin, corresponding to the elevator door under installation. The simulation model shall be understood herein to correspond to the elevator door system 110 under installation at a predefined accuracy. The accuracy may be defined at an entire elevator door system level or at an entity level as mentioned. The accuracy may e.g. be at a level that the simulation model exactly corresponds the elevator door system 110 under installation or at least an entity of the elevator door system 110 in the simulation model corresponds e.g. in structure and/or in its operational sense to the corresponding entity in the elevator door system 110 under installation. In any approach the simulation model shall be such that the simulation data generated with the simulation model is applicable in the context of the elevator door system 110 under installation at a required level. As regards to the simulation, the simulation model 180 is executed with various input parameters and/or in any other manner so as to generate training data to train the machine-learning model executed by the computing apparatus 170. Thus, the operation of the elevator door system 110 is simulated with the simulation model 180 in a various manner. For example, the simulation data may be generated so that the simulation model 180 is executed with parameters causing the simulation model 180 to follow a normal operation of the elevator door system 110 and/or its entities therein. Alternatively or in addition, the simulation model 180 may be executed with parameters causing the simulation model 180 to end up various error situations which may be considered as a malfunctioning of the elevator door system 110 and/or an entity therein corresponding to the simulation model 180. Thus, the training data generated by simulating the simulation model 180 may be considered to comprise data, which is descriptive of an acceptable operation of the elevator door system 110 in the predefined extent, and data, which is descriptive of an unacceptable operation of the elevator door system 110 in the predefined extent. In some embodiments the training data may only define one of the mentioned operations, i.e. that the training data is descriptive of the acceptable operation of the elevator door system 110 or that the data is descriptive of the unacceptable operation of the elevator door system 110. In such an approach the executing entity of the machine-learning model may be configured to execute it so that if the trained machine-learning model does not detect the state, i.e. the operation type of the elevator door system 110, it is trained to detect, it may conclude that it generates an outcome indicative of the other state (cf. acceptable operation / unacceptable operation).

In some embodiments the training of the machine-learning model may apply further data in addition to the simulation data generated with the simulation model 180. Namely, there may be available history data generated e.g. by one or more existing elevator door systems corresponding with a predefined accuracy the one under evaluation. The history data may refer to an operational data of the existing elevator door system which is received from the system data of the elevator door system or from a sensor arrangement arranged to measure at least some operational parameters of the existing elevator door system(s) applicable in the training of the machine-learning model.

As indicated above the training of the machine-learning model may be executed in the computing apparatus 170 with the generated training data. In response to the training the trained machine-learning model may be executed to analyse the data received 210. As is derivable from above the machine-learning model may be trained to execute a classification task to the data input to it in order to decide if - based on the data input to the machine-learning model - the elevator door system 110 operates in an acceptable manner or in an unacceptable manner. The previous of these corresponds to a situation that the quality of the elevator door installation is acceptable 230A and the latter corresponds to a situation that the quality of the elevator door installation is unacceptable 230B.

Depending on the implementation of the machine-learning model and a format of the training data the machine-learning model may also be configured to output, in addition to the above-described detection result, data identifying at least one entity of the elevator door system 110 causing the detection result to correspond to the unacceptable operation of the elevator. Such an approach may require that the training data also defines an entity causing the detection result descriptive of the unacceptable operation of the elevator door system 110, which is then in the internal operation of the machine-learning model also generated as an output e.g. together with the detection result or integrated to the detection result. Naturally, corresponding additional data may also be generated, or associated to, in a situation that the elevator door system 110 is detected to operate in an acceptable way.

In the foregoing description at least some of the aspects of the invention are described in an environment wherein the computing apparatus used for training the machine-learning model is the same that performs the evaluation of the installation quality of the elevator door system 110, or any entity of the elevator door system 110, i.e. receives the measurement data. However, the machine-learning model may be generated and trained in another computing apparatus and the trained model is then transferred to another computing apparatus configured to perform the generation of the data descriptive of the quality of the installation of the elevator door as described. For example, the computing apparatus 170 configured to perform the generation of the data may be a mobile device carried by a technician and which is used for evaluating the installation at the site. For example, the mobile device may be communicatively connected to the elevator door system 110 in a manner that the data required for performing the evaluation for the generation of the data descriptive of the quality of the elevator door installation may be received 210.

The invention as described is especially suitable for evaluating the installation quality based on lock clearance. In order to do that the simulation data generated with the simulation model 180 may represent the door coupling during different operational cycles of the elevator door. In other words, the simulation model 180 is run with settings defining a desired operation of the elevator door with the feature of the door coupling or so that the simulation data is generate over the whole operational cycle of the elevator door, but only portions descriptive of the door coupling are captured for further use. Thus, the simulation model 180 generates values of the predefined parameters descriptive of the operation of the elevator door as desired, which parameters may represent a speed of the operation (cf. opening / closing) of the elevator door and a position of the door belt over the operation cycle. In other words, the simulation with acceptable settings of the elevator door also comprises that the door clearance is within the limits, it is possible to generate curves representing the mentioned parameters over the predefined operational cycles as is described in more detail in the following. The curves, i.e. the curve values over time, from a number of simulation cycles may be used for training the machine-learning model to evaluate the installation quality of the elevator door when respective measurement data gathered over the corresponding operational cycles of the elevator door are input to the machine-learning model. Thus, the evaluation in the described manner may generate a detection result indicating at least inaccuracy in the installation of the elevator door due to that the lock clearance does not meet the requirements.

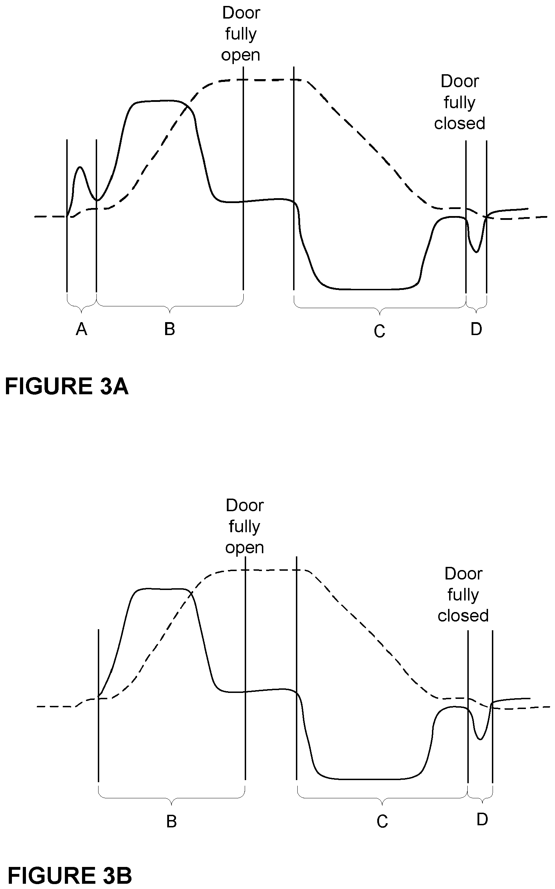

Figures 3A and 3B illustrate schematically some aspects of the operational curves descriptive of various parameters over an operational cycle wherein the curves are generated with the simulation model 180. In general, the simulations for example of the door speed and of the belt position may be performed by applying so-called physics-based simulations for predefined cycles of the door operation starting from different possible states, such as for a situation that an elevator car arrives to a new floor and continues traveling therefrom as well as for a situation wherein the elevator car resides at a floor and the coupler is relaxed (no door command pending).

In Figure 3A the simulation is performed for a situation in which the elevator car arrives to a new floor and there are active calls pending to a next floor. Due to that the elevator car is traveling before landing to the new floor, the elevator door is locked, i.e. such a command is maintained until the landing. Now, in response to the landing the door coupler is activated (section referred with A in Fig. 3A), i.e. the coupling occurs, and the speed of the elevator car door as well as the change in belt position during the section A is shown in Figure 3A. The speed curve is the solid line whereas the belt position is shown with the dotted line. Now, in response to the activation of the coupler, the actual door opening, (i.e. opening of the landing door, which is now coupled with the car door) is initiated (section referred with B in Fig. 3A). As derivable the speed of the elevator door accelerates to the maximum speed and is then again reduced prior to reaching the opening limit of the elevator door. Therein the speed of the elevator door is naturally zero. Correspondingly, the position of the door belt reaches the position at which the elevator door is fully open (i.e. reached the opening limit). At some point the elevator door is triggered to close and the closing occurs during the section referred with C in Figure 3A. The speed of the elevator door is negative compared to the opening phase due to its direction and the belt position moves to the opposite direction than during the opening. Finally, during the section referred with D in Figure 3A the coupling is inactivated, i.e. the landing door and the elevator car door are released from each other, and the final adjustments in the car door speed and the belt position occur. At the end of the cycle the elevator door is locked and the command is set accordingly in order to allow the elevator car to travel to the next floor.

Figure 3B illustrates the situation when the starting point is that the elevator car has resided at a floor over a predefined period of time, i.e. not serving any calls, which causes the elevator door operation to start from so-called relaxed cycle. This corresponds to that the elevator door is closed, but there is not pending command with respect to the elevator door and therefore the coupler is not activated in response to instructing the elevator door to open. Power supply to the door motor is also interrupted. This results that the curves differ from the one shown in Figure 3A here in the beginning. In Figure 3B the same remarks as done with respect to Figure 3A may be made as relates to the phases referred with B, C and D in both Figures 3A and 3B as well as to the other operations in between and after the mentioned phases. For avoidance of doubt the coupling operation occurs during the phase D in the situation schematically illustrated in Figure 3B wherein the elevator car door and the landing door are uncoupled from each other, i.e. the coupling is inactivated.

For avoidance any doubt the aim of Figures 3A and 3B is to show non-limiting examples of the simulation data in the context of the door opening and especially the variation in the door coupling which simulation data refers to the data output from the simulation that is applied for training the machine-learning model as described. The simulation data may be generated with various settings of the simulation model 180 wherein the lock clearance is kept within predefined limits, but other parameters are changed within a framework that the elevator door operates in an acceptable manner. By training the machine-learning model with the data generated with the simulation it is achieved to detect variations from real-world measurement data input to it.

Further simulation data may be generated for a situation that there are not pending calls for the elevator car arriving to a floor which leads to the coupler relation after a predefined period of time. In such a situation simulation data corresponds to the simulation data shown in Figure 3A, but instead of activation of the door closing command, the coupler is relaxed which may cause some change in the respective curves. It may also be required that the simulation data is generated for the situation of Figure 3B with a difference that even if the elevator door is opened and closed it does not lead to a travel of the elevator car, i.e. the door lock command is not activated and the coupler is relaxed.

It is also worth noting that in case especially the operation of the coupler, i.e. the coupling phase, is under interest the training of the machine-learning model may be focused with the simulation data defining only those sub-phases representing the operation of the coupler. In other words, either the simulation data is generated only on the respective sub-phase or the sub-phase is separated from the simulation data over the full operational cycle of the elevator door computationally. Alternatively, the training of the machine-learning model may be performed with a simulation data descriptive of the full operational cycle of the elevator door so as to enable the machine-learning model to receive measurement data over a full operational cycle of the elevator door. However, in order to optimize the data to be analyzed the measurement data input to the machine-learning model may only comprise the portions descriptive of the desired operation, e.g. the door coupling phase. Such data may be generated either by obtaining measurement data over such sub-phases or by computationally separating such portions from the measurement data over the full operational cycle of the elevator door.

The approach according to the present invention in which only specific sub-phases of the simulation data are applied for training the machine-learning model has an advantage that it enhances and speeds up the training phase since the training needs not to be performed over the full operational cycle of the elevator door. Furthermore, by separating an operation of a sub-unit of the elevator door system from the whole operation of the elevator door the trained machine-learning model may be used for evaluating the installation quality for a wider range of the elevator doors than just the one corresponding to the elevator door used in the simulation model. This is because the same entity, such as the door coupler, may be used in a plurality of elevator doors differing from each other, such as in an elevator door family e.g. consisting of elevator doors with different sizes, and in spite of the door type the operation of the door coupler, i.e. the coupling system, is the same. Therefore, by training the machine-learning model with the training data, cf. simulation data, descriptive of the operation of the coupler (i.e. with the data descriptive of the coupling phase) in one elevator door type, the same trained machine-learning model may be used for evaluating the installation quality in all elevator doors having the same coupling system.

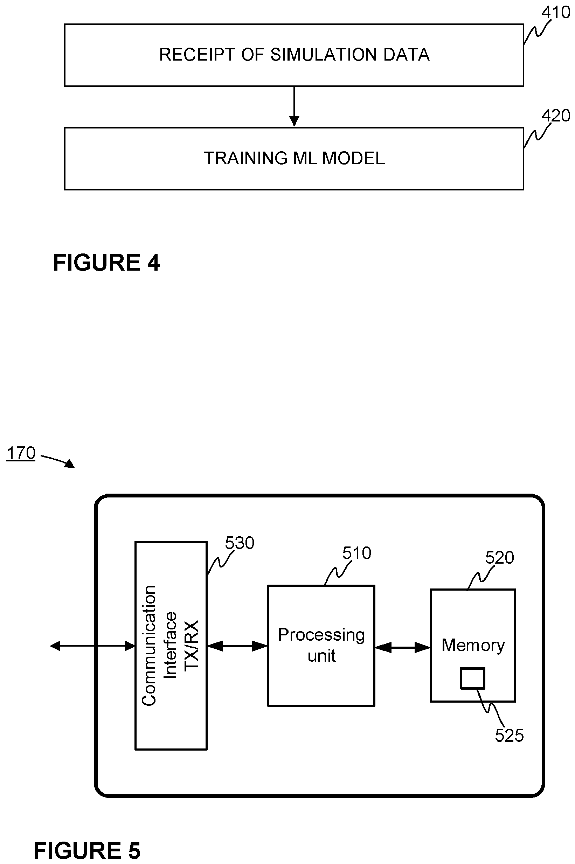

Figure 4 illustrates schematically a method for training of the machine-leaning model in order to evaluate a quality of an installation of an elevator door. The entity performing the training may be a computing apparatus, such as the one referred with a reference 170 in Figure 1. The method comprises a step of receiving 410 simulation data from a simulation model of an elevator door as described and training 420 the machine-learning model with at least part of the simulation data being descriptive of an operation of an entity of the elevator door that is common to a plurality of elevator door types. Specifically, the at least part of the simulation data may be descriptive of a coupling phase of the elevator door. In case the machine-learning model is trained for its task in another computing apparatus 170 than where it is executed in its task, the trained machine-learning model is transferred to the other computing apparatus in a known manner applied in transporting data from one computing apparatus to another.

An example of an apparatus suitable to execute the methods is schematically illustrated in Figure 5. In other words, the apparatus shown in Figure 5 is applicable for performing the simulation of the elevator door, the training of the machine-learning model and/or the evaluation of the quality of the installation of the elevator door. For sake of clarity, it is worthwhile to mention that the block diagram of Figure 5 depicts some components of an entity that may be employed to implement a functionality of the apparatus 170. The apparatus of Figure 5 comprises a processor 510 and a memory 520. The memory 520 may store data, such as pieces of data as described, but also computer program code 525 causing the operation in the described manner. The apparatus may further comprise a communication interface 530, such as a wireless communication interface or a communication interface for wired communication, or both to communicate with other entities as described. The communication interface 530 may thus comprise one or more modems, antennas, and any other hardware and software for enabling an execution of the communication e.g. under control of the processor 510. Furthermore, I/O (input/output) components may be arranged, together with the processor 510 and a portion of the computer program code 525, to provide a user interface for receiving input from a user, such as from a technician, and/or providing output to the user of the apparatus when necessary. In particular, the I/O components may include user input means, such as one or more keys or buttons, a keyboard, a touchscreen, or a touchpad, etc. The I/O components may include output means, such as a loudspeaker, a display, or a touchscreen. The components of the apparatus 170 may be communicatively connected to each other via data bus that enables transfer of data and control information between the components.

The memory 520 and at least a portion of the computer program code 525 stored therein may further be arranged, with the processor 510, to cause the apparatus to perform at least a portion of any of the methods as is described herein. The processor 510 may be configured to read from and write to the memory 520. Although the processor 510 is depicted as a respective single component, it may be implemented as respective one or more separate processing components. Similarly, although the memory 520 is depicted as a respective single component, it may be implemented as respective one or more separate components, some, or all of which may be integrated / removable and / or may provide permanent / semi-permanent / dynamic / cached storage.

The computer program code 525 may comprise computer-executable instructions that implement functions that correspond to steps implemented in the method when loaded into the processor 510 of the respective apparatus 170. As an example, the computer program code 525 may include a computer program consisting of one or more sequences of one or more instructions. The processor 510 is able to load and execute the computer program by reading the one or more sequences of one or more instructions included therein from the memory 520. The one or more sequences of one or more instructions may be configured to, when executed by the processor 510, cause the apparatus, such as a computer, to perform at least some of the methods as described. Hence, the apparatus may comprise at least one processor 510 and at least one memory 520 including the computer program code 525 for one or more programs, the at least one memory 520 and the computer program code 525 configured to, with the at least one processor 510, cause the apparatus to perform at least some of the methods.

The computer program code 525, or at least some portion of it, may be provided e.g. a computer program product comprising at least one computer-readable non-transitory medium having the computer program code 525 stored thereon, which computer program code 525, when executed by the processor 510 causes the apparatus to perform the method. The computer-readable non-transitory medium may comprise a memory device or a record medium, such as a CD-ROM, a DVD, a Blu-ray disc, or another article of manufacture that tangibly embodies the computer program. As another example, the computer program may be provided as a signal configured to reliably transfer the computer program.

Still further, the computer program code 525 may comprise a proprietary application, such as computer program code for causing an execution of the method in the manner as described in the description herein.

For sake of completeness, it is worthwhile to mention that the computer program code 525 may comprise a portion that represents the machine-learning model as described herein.

Any of the programmed functions mentioned may also be performed in firmware or hardware adapted to or programmed to perform the necessary tasks.

For sake of completeness it is worthwhile to mention that the entity performing the method in the role of the apparatus 170 may also be implemented with a plurality of apparatuses, such as the one schematically illustrated in Figure 5, as a distributed computing environment corresponding to an apparatus. For example, one of the apparatuses may be communicatively connected with the other apparatuses, and e.g. share the data of the respective method, to cause another apparatus to perform at least one other portion of the method. As a result, the method performed in the distributed computing environment generates the control signal indicative of the assignment of the responsibility as described.

For avoidance of any doubt a dedicated apparatus e.g. corresponding to the one schematically illustrated in Figure 5 may be arranged for each operations as described, i.e. for the simulation operation, for the training of the machine-learning model operation, and for performing the evaluation of the installation quality of the elevator door. Alternatively at least one apparatus may be arranged to perform a plurality of the mentioned operations.

The specific examples provided in the description given above should not be construed as limiting the applicability and/or the interpretation of the appended claims. Lists and groups of examples provided in the description given above are not exhaustive unless otherwise explicitly stated.

## Claims

1. A computer-implemented method for generating data descriptive of a quality of an installation of an elevator door, the method is performed by a computing apparatus (170) configured to execute a machine learning-model trained at least with a simulation data of a simulation model (180) corresponding to an installed elevator door for evaluating the quality of the installation of the elevator door, the method comprises:
receiving (210) data descriptive of an operation of the installed elevator door, the data is generated over at least portion of an operational cycle of the installed elevator door,
inputting (220) the data descriptive of an operation of the installed elevator door to the machine-learning model,
setting (230), in accordance with an output from the machine-learning model, a detection result to express one of the following: (i) the installed elevator door operates in an acceptable manner, (ii) the installed elevator door operates in an unacceptable manner.

2. The method according to claim 1, wherein the data descriptive of the operation of the installed elevator door is received (210) from a coupling phase of the elevator door.

3. The method according to claim 2, wherein the data descriptive of the operation of the installed elevator door correspond to data descriptive of a belt position and data descriptive of a speed of the elevator door during the coupling phase of the elevator door.

4. A computing apparatus (170) for generating data descriptive of a quality of an installation of an elevator door, the computing apparatus (170) is configured to execute a machine learning-model trained at least with a simulation data of a simulation model (180) corresponding to an installed elevator door for evaluating the quality of the installation of the elevator door, the computing apparatus (170) further configured to:
receive (210) data descriptive of an operation of the installed elevator door, the data is generated over at least portion of an operational cycle of the installed elevator door,
input (220) the data descriptive of an operation of the installed elevator door to the machine-learning model,
set (230), in accordance with an output from the machine-learning model, a detection result to express one of the following: (i) the installed elevator door operates in an acceptable manner, (ii) the installed elevator door operates in an unacceptable manner.

5. The computing apparatus (170) according to claim 4, wherein the computing apparatus (170) is arranged to receive (210) the data descriptive of the operation of the installed elevator door from a coupling phase of the elevator door.

6. The computing apparatus (170) according to claim 5, wherein the data descriptive of the operation of the installed elevator door correspond to data descriptive of a belt position and data descriptive of a speed of the elevator door during the coupling phase of the elevator door.

7. A computer program comprising instructions to cause the computing apparatus (170) of claim 4 to execute the steps of the method of claim 1.

8. A computer-implemented method for training a machine-learning model for evaluating a quality of an installation of an elevator door, the method, performed by a computing apparatus (170), comprises:
receiving (410) simulation data from a simulation model of an elevator door,
training (420) the machine-learning model with at least part of the simulation data being descriptive of an operation of an entity of the elevator door that is common to a plurality of elevator door types.

9. The method of claim 8, wherein the at least part of the simulation data is descriptive of a coupling phase of the elevator door.

10. A computing apparatus (170) for training a machine-learning model for evaluating a quality of an installation of an elevator door, the computing apparatus (170) is configured to:
receive (410) simulation data from a simulation model of an elevator door,
train (420) the machine-learning model with at least part of the simulation data being descriptive of an operation of an entity of the elevator door that is common to a plurality of elevator door types.

11. The method of claim 10, wherein the at least part of the simulation data is descriptive of a coupling phase of the elevator door.

12. A computer program comprising instructions which, when the program is executed by a computing apparatus, cause the computing apparatus to carry out the method of claim 8.
